(19) Europäisches Patentamt
European Patent Office
Office européen des brevets

(11) **EP 1 716 634 B1**

(12) **EUROPEAN PATENT SPECIFICATION**

(45) Date of publication and mention
of the grant of the patent:
**04.03.2020 Bulletin 2020/10**

(51) Int Cl.:
*H03L 7/085* (2006.01)   *H03L 7/099* (2006.01)
*H03L 7/199* (2006.01)

(21) Application number: **05764681.2**

(86) International application number:
**PCT/US2005/001142**

(22) Date of filing: **13.01.2005**

(87) International publication number:
**WO 2005/083880 (09.09.2005 Gazette 2005/36)**

(54) **IMPROVEMENT OF THE COARSE TUNING TIME IN PLL WITH LC OSCILLATOR**

VERBESSERUNG DER GROBABSTIMMZEIT IN EINEM PLL MIT LC-OSZILLATOR

AMELIORATION DU TEMPS D'ACCORDAGE GROSSIER DE BOUCLES A PHASE ASSERVIE COMPORTANT UN OSCILLATEUR

(84) Designated Contracting States:
**AT BE BG CH CY CZ DE DK EE ES FI FR GB GR HU IE IS IT LI LT LU MC NL PL PT RO SE SI SK TR**

(30) Priority: **20.02.2004 US 545933 P**

(43) Date of publication of application:
**02.11.2006 Bulletin 2006/44**

(73) Proprietor: **GCT Semiconductor, Inc.**
**San Jose, CA 95131 (US)**

(72) Inventors:
• **LEE, Kang, Yoon**
  **Youngdeungpo Gu,**
  **Seoul (KR)**
• **KOO, Yido**
  **Youngdeungpo-Gu,**
  **Seoul (KR)**
• **LEE, Jeong-Woo**
  **Youngdeungpo-Gu,**
  **Seoul (KR)**
• **PARK, Joonbae**
  **Seoul (KR)**
• **LEE, Kyeongho**
  **Kwanak Gu,**
  **Seoul (KR)**

(74) Representative: **Fennell, Gareth Charles et al**
**Kilburn & Strode LLP**
**Lacon London**
**84 Theobalds Road**
**London WC1X 8NL (GB)**

(56) References cited:
**US-A- 6 167 245       US-A1- 2002 113 659**
**US-A1- 2002 193 084   US-A1- 2003 202 313**
**US-A1- 2003 210 101   US-A1- 2004 114 302**
**US-A1- 2004 150 485   US-A1- 2004 169 564**
**US-A1- 2004 251 978   US-B1- 6 281 758**

EP 1 716 634 B1

**Description**

**BACKGROUND OF THE INVENTION**

**Field of the Invention**

Embodiments of the present invention relate to circuit design. Particularly, embodiments of the present invention relate to improvements in phase lock loop (PLL) circuits.

**Background of the Related Art**

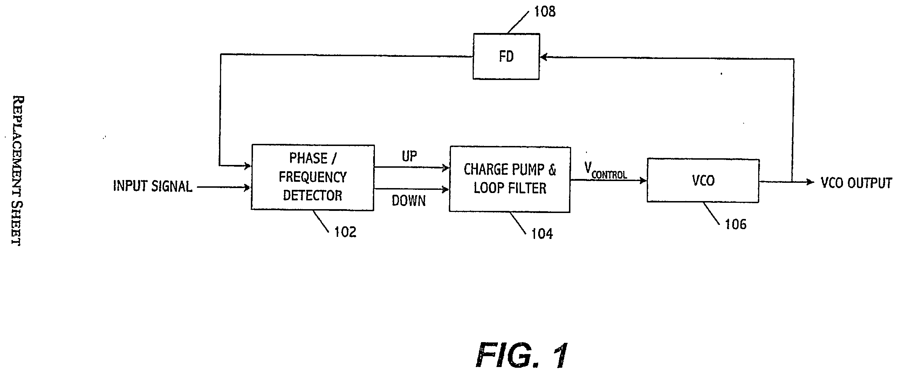

Phase locked loops (PLLs) are widely used in various wireless systems due to its usefulness for digital clock synchronization, frequency synthesizing, and the like. Fig. 1 illustrates a general schematic diagram of a PLL according to the related art. The PLL includes a phase frequency detector 102 (PFD), charge pump (CP) and loop filter (LF) 104, voltage-controlled oscillator 106 (VCO), and frequency divider. PFD 102 compares the phase/frequency of input and output signals and sends the result to CP & LF 104. CP & LF 104 converts the result of comparison in PFD 102 into a DC voltage. PFD 102 generates the "UP" or "DOWN" signal according to whether the input signal leads or lags the output. VCO 106 generates the pulse frequency as a function of the DC voltage (Vcontrol) supplied from CP & LF 104.

In PLL applications, inductor-capacitor VCOs (LC-VCOs) are widely used because of their jitter/phase noise performance, which is typically better than ring oscillators, for example. LC-VCOs are tuned because process variations, which produce tolerances/variations in the various inductor and capacitor components and to cover the required frequency and range.

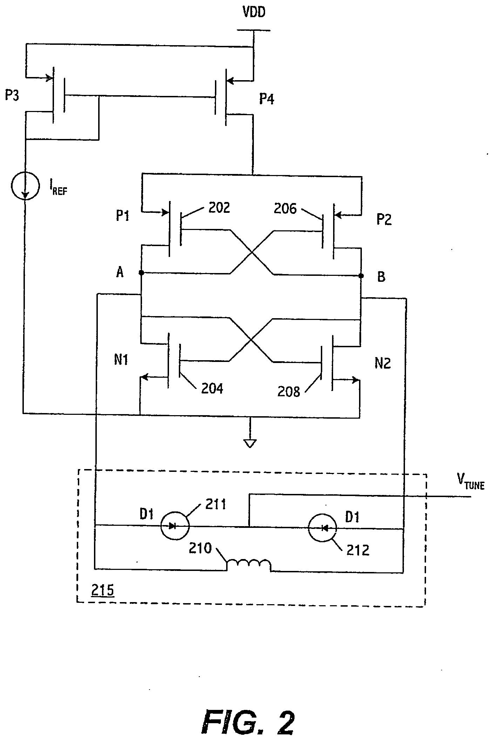

A simple schematic diagram of a related art LC-VCO is illustrated in Fig. 2. Two CMOS inverters 202 and 204 are cross-coupled by connecting the common drain of the first inverter 202 to the common gate of the second inverter 204 and vice versa. The cross-coupled inverters 202 and 204 constitute a multivibrator. The inductor 206 (L) is connected in parallel with the capacitor circuit 210 to form a tank circuit. The capacitor circuit 210 is subdivided into analog varactor 212 (CV) and discrete capacitor array 214 (CD). The discrete capacitor array 214 is used for coarse tuning of the frequency and the varactor is used for fine-tuning. The voltage nodes for controlling the switches of the discrete capacitor array 214 are omitted in this figure for simplicity. This type of VCO has recently been applied in wireless applications, because it provides better phase noise performance than typical varactor-only controlled LC oscillators.

US 2002/0193084A1 describes a radio-frequency (RF) apparatus capable of transmitting RF signals including transmitter path circuitry. The transmitter path circuitry includes a voltage-controlled oscillator (VCO) circuitry. The VCO circuitry generates a first signal that has a first frequency. A divider circuitry couples to the VCO circuitry and, in response to the first signal, the divider circuitry generates a second signal that has a second frequency. The frequency of the second signal equals the frequency of the first signal divided by a number.

FIG. 15 of US 2002/0193084A1 shows a conceptual or block diagram of an example for use in a transmitter circuitry. The example includes an offset-PLL circuitry, VCO circuitry, and a frequency calibration engine. The offset-PLL circuitry may comprise offset-PLL circuitry as shown in FIG. 4 of US 2002/0193084A1 or offset-PLL circuitry as shown in FIG. 8 of US 2002/0193084A1, as desired. The offset-PLL circuitry includes phase detector, loop filter circuitry, and offset mixer circuitry.

FIG. 16 of US 2002/0193084A1 shows a conceptual or block diagram of an example of the VCO circuitry. The VCO circuitry constitutes a resonator-based VCO. The VCO circuitry includes a variable capacitor, a fixed capacitor, an inductor, an equivalent resistance, and an amplifier circuitry. One of the terminals of each of the variable capacitor, the fixed capacitor, the inductor, the equivalent resistance, and the amplifier circuitry couples to the output signal of the VCO circuitry, whereas the other terminal of each of those components couples to a reference terminal.

FIG. 18 of US 2002/0193084A1 illustrates an example of a discretely variable capacitor. The discretely variable capacitor includes a plurality of transistors or switches and a plurality of capacitors (CD0 through CDN). The plurality of transistors constitute N-type metal oxide semiconductor (NMOS) transistors. One terminal of each capacitor in the plurality of capacitors couples to the signal line. Another terminal of each capacitor in the plurality of capacitors couples to a drain terminal of a corresponding NMOS transistor in the plurality of NMOS transistors. A source terminal of each of the NMOS transistors in the plurality of NMOS transistors couples to the reference terminal.

For the circuit depicted in FIG. 18 of US 2002/0193084A1, with simple capacitor/switch circuits coupled together in parallel fashion, the total capacitance for the discretely variable capacitance equals the sum of the capacitances of all capacitors that have their respective switches in the ON (i.e., conducting) state. Thus, one may represent the total capacitance for the discretely variable capacitance as: $C_D = (C_{D0} \cdot B_0) + (C_{D1} \cdot B_1) + ... + (C_{DN-1} \cdot B_{N-1}) + (C_{DN} \cdot B_N)$, where $B_0$ through $B_N$ represent bits of a calibration signal which controls the operation of the NMOS transistors.

If one considers each capacitance value as a multiple of a unit or base capacitance value, $C_0$, times a desired capacitor weighting, W, one may represent the total capacitance as: $C_D = (W_{D0} \cdot C_0 \cdot B_0) + (W_{D1} \cdot C_0 \cdot B_1) + ... + (W_{DN-1} \cdot C_0$

$\cdot B_{N-1})+(W_{DN} \cdot C_0 \cdot B_N)$.

In this example of US 2002/0193084A1, the choice of weighting coefficients defines what values of capacitance are available.

In US 2002/0193084A1 numerous weighting schemes are disclosed to be possible, and the one implemented depends upon the particular design considerations involved. One possible choice for a weighting scheme is an equal weighting scheme, such that all of the weights are the same. In other words, $W_{D0}=W_{D1}= ... =W_{DN-1}=W_{DN}=\lambda$, where $\lambda$ represents a constant. This equal weighting scheme, however, is relatively inefficient because it requires a large number capacitor/switch circuits and a small base capacitor value to provide a large number of capacitor value choices. Another possible weighting scheme is a binary weighting scheme, such that each weight differs from the previous weight by a factor of 2. Thus,

$$W_{D0}=1$$
$$W_{D1}=2,$$
$$W_{D2}=4$$
$$W_{DN-1}=2^{N-1}, \text{ and}$$
$$W_{DN}=2^N.$$

US 2002/0193084A1 describes that although this binary weighting scheme is relatively efficient in allowing the selection of a wide range of capacitance values with a limited number of capacitor/switch circuits, this scheme suffers from practical implementation problems due to differential non-linearities (DNL) in manufacturing the capacitance values. In contrast, the equal weighting scheme has a low occurrence of problems with DNL.

Possible compromise weighting schemes between the equal and binary weighting schemes include radix less-than-two and mixed radix weighting schemes. US 2002/0193084A1 discloses a radix less-than-two weighting scheme, for example, such that each weight is a factor (i.e., the radix) less than 2 (e.g., 7/4) different from the previous weight:

$$W_{D0}=1,$$
$$W_{D1}=7/4,$$
$$W_{D2}=(7/4)^2$$
$$W_{DN-1}=(7/4)^{N-1}, \text{ and}$$
$$W_{DN}=(7/4)^N.$$

US 2002/0193084A1 discloses that one may use the discretely variable capacitance to provide a coarse tuning of the oscillation frequency of the VCO circuitry near the desired output frequency. The capacitance of the continuously variable capacitance then need only vary enough to cover the frequency range between the steps available through the discrete changes of the digitally controlled discretely variable capacitor and to cover any post-calibration component drifts (for example, because of temperature and voltage variations, and the like) and variations due to signal modulation. This reduction in the required capacitance variation eliminates the need for a large capacitance variation that typically requires the use of a variable reverse-biased diode (or varactor), as conventional VCO circuitries employ. Avoiding a large capacitance variation in turn results in reduced noise susceptibility. By eliminating the need for a varactor, the disclosure of US 2002/0193084A1 seeks to provide a frequency synthesis solution suitable for integration in a single CMOS integrated circuit.

SUMMARY OF THE INVENTION

Embodiments of the present invention include tuning methods and apparatuses for PLLs that each include an LC oscillator. Embodiments of the present invention include adaptively controlling the bit-comparison time to provide the smallest coarse tuning time. The bit comparison time is scaled inversely to the amount of redundancy of corresponding weighted capacitors in a capacitor array of the LC oscillator.

Additional advantages, objects, and features of the invention will be set forth in part in the description which follows and in part will become apparent to those having ordinary skill in the art upon examination of the following or may be learned from practice of the invention. The objects and advantages of the invention may be realized and attained as particularly pointed out in the appended claims.

BRIEF DESCRIPTION OF THE DRAWINGS

The invention will be described in detail with reference to the following drawings in which like reference numerals refer to like elements wherein:

Fig. 1 illustrates a general schematic diagram of a PLL according to the related art;

Fig. 2 illustrates a simple schematic diagram of a related art LC-VCO;

Fig. 3. illustrates a block diagram of a PLL incorporating the LC- VCO with discrete capacitors as part of the tank circuit in phase lock operation;

Fig. 4 illustrates a block diagram of the PLL during the coarse tuning process;

Fig. 5 illustrates an example of the coarse tuning process with key timing parameters;

Fig. 6 illustrates a block diagram of detection logic in the coarse tuning controller;

Fig. 7 illustrates an arrangement of a simplified timing diagram of the coarse tuning process;

Fig. 8 illustrates a simplified timing diagram of the coarse tuning process according to an embodiment of the present invention; and

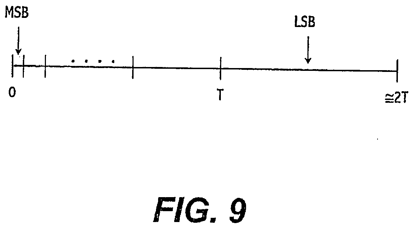

Fig. 9 is a diagram showing a total bit-comparison time in accordance with the present invention which is significantly less than the total bit-comparison time of the circuit in Fig. 8.

## DETAILED DESCRIPTION OF PREFERRED EMBODIMENTS

In the following detailed description of preferred embodiments, reference is made to the accompanying drawings that show, by way of illustration, specific embodiments in which the invention may be practiced. In the drawings, like numerals describe substantially similar components throughout the several views. These embodiments are described in sufficient detail to enable those skilled in the art to practice the invention. Other embodiments may be utilized, and structural, logical, and intellectual changes may be made without departing from the scope of the present invention. Moreover, it is to be understood that various embodiments of the invention, although different, are not necessarily mutually exclusive. For example, a particular feature, structure, or characteristic described in one embodiment may be included within other embodiments. The following detailed description is not to be taken in a limiting sense, and the scope of the present invention is defined only by appended claims, along with the full scope of equivalence to which such claims are entitled.

Embodiments of the present invention disclose methods to reduce the total bit-comparison time of the coarse tuning period. For example, the trade-off between the coarse tuning time and the accuracy of the coarse tuning can be resolved by adopting weighted comparison time for the coarse tuning of the each bit decision. Thus, the bit-comparison time for each coarse tuning bit can be set differently according to its comparison resolution.

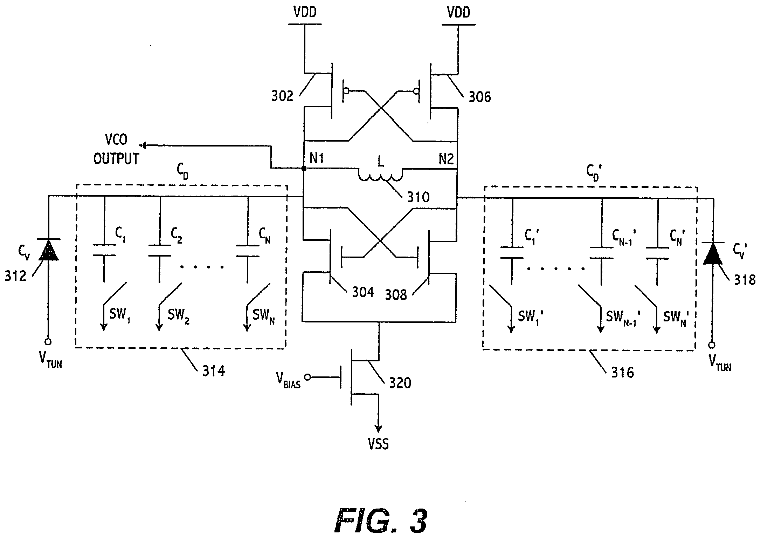

Figure 3 illustrates a block diagram of a PLL incorporating the LC- VCO with discrete capacitors as part of the tank circuit in phase lock operation. During the normal operating mode, the PFD and the charge pump 302 via low pass filter 304 control the analog varactor 306 to have an exact frequency and phase lock. However, when the PLL becomes activated or tries to change the desired frequency, the PLL enters into the coarse tuning period to achieve coarse frequency lock. This coarse frequency acquisition process is performed using the coarse tuning controller 310, which turns on and off the appropriate capacitor(s) 312 to move the output frequency of the VCO 308 as close as possible to the desired frequency.

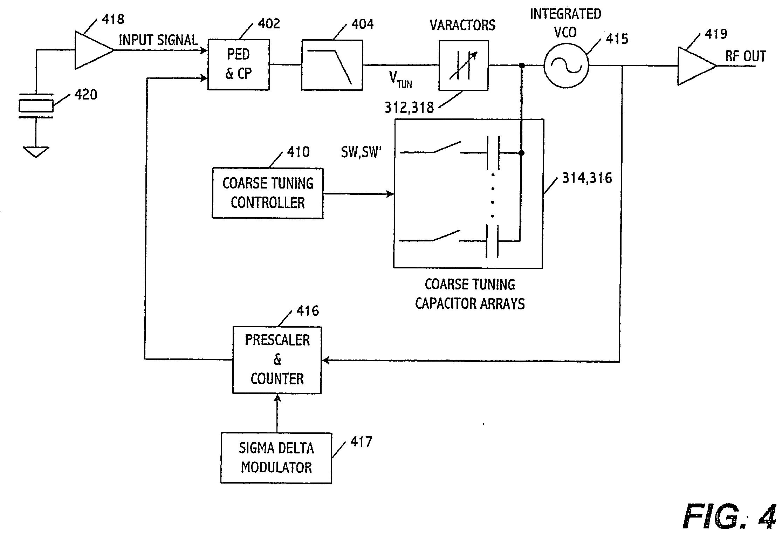

The block diagram of the PLL during the coarse tuning process according to Fig. 3 is illustrated in Fig. 4. In coarse tuning process, the Bias Generator generates a fixed control voltage for the varactor of the VCO. Hence, the capacitance of the varactor (e.g., Cv in Fig. 2) is fixed during the coarse tuning. Instead of controlling the capacitance of the varactor, the frequency of the VCO is determined by the discrete coarse tuning capacitors. The Crystal Oscillator provides the reference for coarse tuning. The Prescaler & Counter counts the number of VCO clocks during the pre-determined duration for the desired lock frequency. Here, the pre-determined duration is the high duration of the EN_COUNTER. In each coarse tuning stage, the Digital Comparator compares the reference number and the counter value from the Prescaler&Counter and generates UP/DOWN signal to determine whether the VCO frequency is higher or lower than the desired frequency. With the UP/DOWN signal, the capacitor of each stage is set as ON or OFF. The Reset Generator & Counter Controller resets the counter value of the Prescaler&Counter for each coarse tuning stage.

Several methods are published in the related art that perform coarse tuning and fine-tuning control of the VCO (see, e.g., U.S. Patent No. 6,137,372 and "A CMOS Self-Calibrating Frequency Synthesizer", IEEE Journal of solid-state circuits, Vol. 35, No. 10, 2000. Each reference is hereby incorporated by reference herein in its entirety). The accuracy of the coarse tuning process is relevant to reducing the varactor size. Since the size of the varactor is inversely proportional to the phase noise, it is advantageous to reduce the size of the varactor to improve the phase noise performance. As the coarse tuning process is performed more accurately, the smallest capacitor should be designed to provide a fine frequency step size during coarse tuning.

To perform the coarse tuning process accurately, both frequency error detection and the step size of the smallest capacitor should be determined accurately. Even though modern process techniques provide well-matched capacitors in terms of capacitance, this error can be minimized or compensated during the coarse tuning for a more accurate coarse tuning. The design of the frequency error detector during the coarse tuning is related to the coarse tuning time, which will be discussed below in the following paragraphs.

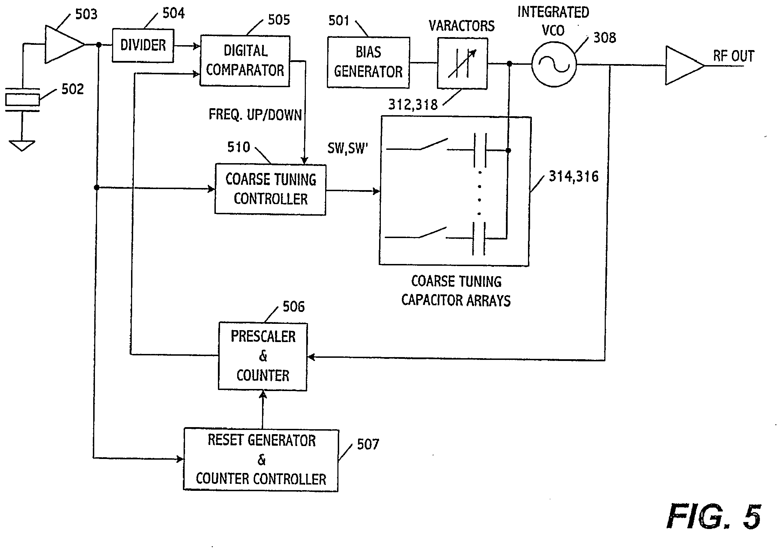

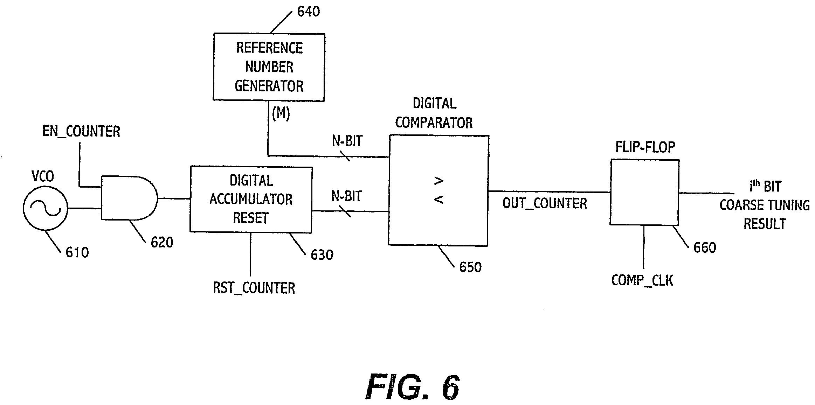

Figs. 5 and 6 illustrate an example of the coarse tuning process with key timing parameters and a block diagram of detection logic in the coarse tuning controller, respectively. The coarse tuning process starts whenever the desired frequency is changed or after power-up. Since the coarse tuning process is a kind of frequency tracking, the digital accumulator 630 is used to estimate the period of the VCO 610. This result is compared with the reference-timing signal from the external crystal clock. In the particular implementation of the coarse tuning illustrated in Fig. 6, the digital accumulator 630 (or counter) is periodically reset by the RST_COUNTER signal generated by the coarse tuning controller. This counting operation is masked by the EN_COUNTER signal. As illustrated in Fig. 6, the operation of the counter is enabled (e.g., using AND gate 620) only when the EN_COUNTER is high. When the output of the accumulator/counter 630 exceeds the reference number (e.g., "M" in Figure 6) as determined by digital comparator 650, the OUT_COUNTER signal becomes high. This OUT_COUNTER signal and COMP_CLK signal from the coarse tuning controller are used for lead-and-lag detection of the frequency, by flip-flop 660.

As illustrated in Fig. 5, the OUT_COUNTER signal becomes high at 510 prior to low-to-high transition of the COMP_CLK signal. According to the frequency error, the latched value will vary from one to zero at 520. In the illustration of Fig. 5, the VCO frequency is determined to be greater than expected. This polarity at the latched output (e.g., flip-flop 660) can be used to decide the polarity of the switch connected to the (i-th) capacitor in the VCO.

When the PLL receives the channel information, the coarse tuning controller converts the channel information to appropriate timing parameters for the coarse tuning. For example, when the desired target frequency is 1GHz and the external reference clock frequency is 20MHz, the coarse tuning controller works with this 20MHz external clock signal to generate RST_COUNTER, EN_COUNTER, the reference number, and COMP_CLK signals.

For example, let's assume that the high duration of the EN_COUNTER is set as 1 us and the target VCO frequency is 1 GHz. Here, the "1us" for the duration of the EN_COUNTER is a design value and can be changed to other value according to the accuracy of the coarse tuning process. In this example, the external clock is divided by 20 (20/20MHz= 1us) to generate the high duration of the EN_COUNTER signal. The reference number is determined from the division of the EN_COUNTER by the duration of the target VCO frequency. Hence, in this example, the reference number is 1000 (= 1us/(1/1GHz)). This reference number is compared with the counter value of the Prescaler&Counter at the Digital Comparator. The COMP_CLK is synchronized with the falling edge of the EN_COUNTER and used as a timing clock in the Digital Comparator. The RST_COUNTER is a reset signal for each coarse tuning stage and high during one external clock after the EN_COUNTER goes from high to low.

The accuracy of the coarse tuning process is a design parameter to be decided and is mainly determined by the EN_COUNTER signal. In Fig. 5 the $T_{c,1bit}$ means the total cycle time for switch on and off of one bit in the coarse tuning, which is mainly determined by operating time of the counter, $T_{c,counter}$.

A limiting factor for the accurate coarse tuning is the uncertainty of the lead-and-lag detection logic in Fig. 6. Assuming the goal of the coarse tuning is to discriminate the frequency difference of 1MHz, then two VCO frequencies of 0.9995GHz and 1.0005GHz should be detected, for example. When the duration of the EN_COUNTER is set to 1$\mu$s, then the reference number ("M" in Fig. 6) should be set to 1000(= 1$\mu$s/1ns). The time differences between the rising edge of EN_COUNTER and the rising edge of the OUT_COUNTER are 1.0005 $\mu$s for the VCO frequency of 0.9995GHz and 0.9995$\mu$s for the VCO frequency of the 1.001GHz. When there is no timing uncertainty, the former case will produce frequency "DOWN" signal and the latter case will produce frequency "UP" by the lead-and-lag detection logic. However, if the timing uncertainty from the lead-and-lag detection logic is 1ns, the two results can be same. Thus, it is uncertain whether those two VCO frequencies can be distinguished by the lead-and-lag detection logic.

When the timing uncertainty is fixed, the accuracy can be improved by increasing the reference number or the duration of EN_COUNTER. Assuming that the reference number is increased by 10 times, then the time differences will be 10.005 $\mu$s and 9.995 $\mu$s for those two cases. Since the timing margin of 5ns is larger than the timing uncertainty of 1ns, the decision will be correct. In other words, 0.1% of the initial frequency difference of the VCO results in 10ns of the difference in time rather than 1ns in former case. Since this value is large enough to compensate the uncertainty from the lead-and-lag detection logic, the desired accuracy can be obtained.

However, the penalty for the improvement in coarse tuning is an increase of the comparison time or the time required for the coarse tuning. If the number of bits to be determined is 10bits, then the time required to finish the coarse tuning will be 10 times for the 1bit decision case. In summary, as the number of the bits or the accuracy for the coarse tuning is increased, the coarse tuning time is also increased.

After finishing the coarse tuning, the PLL enters into the phase lock operation (e.g., as illustrated in Fig. 3). Since the total lock time of the PLL includes the time required for the coarse tuning, an accurate coarse tuning tends to increase the total lock time. Further, as stated earlier, the size reduction of the analog varactor can improve the phase noise performance, because the analog varactor typically has a poor quality factor when compared to a discrete capacitor array used for coarse tuning. Additionally, the size of the analog varactor can be reduced only when the accurate coarse tuning is guaranteed. If the coarse tuning is less accurate, then the operating range of the analog varactor can extend beyond the desired frequency and no phase and frequency lock can be achieved. Accordingly, the coarse tuning should be performed very fast both for good phase noise performance and small lock time.

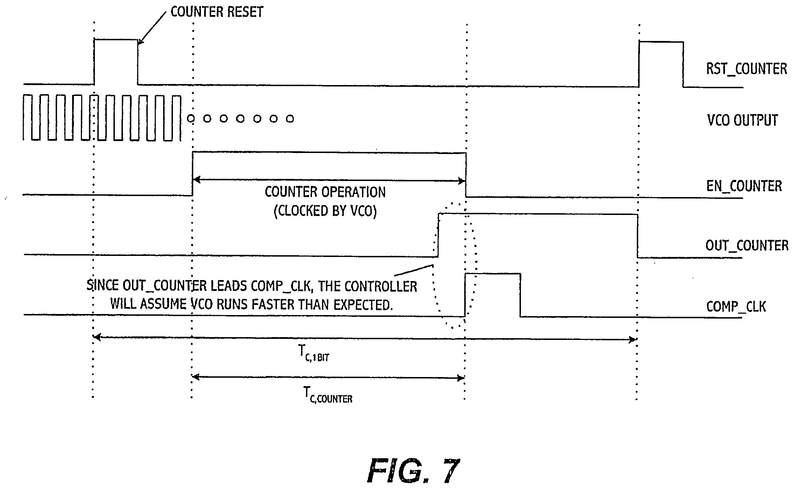

Fig. 7 illustrates a simplified timing diagram of the coarse tuning process for comparison purposes. As noted above, the final resolution of the coarse tuning should be set small enough to allow reduction of the varactor. However, the coarse tuning time for the each bit also is set large enough to cover all of the variation in decision process. Those variations can come from the uncertainty of the lead-and-lag detection logic, other logic delay, noise (e.g., power supply noise), start-up time of the each component, and the like. Accordingly, when the number of the coarse tuning bits increases, the total time required for the coarse tuning increases linearly as illustrated in Fig. 7.

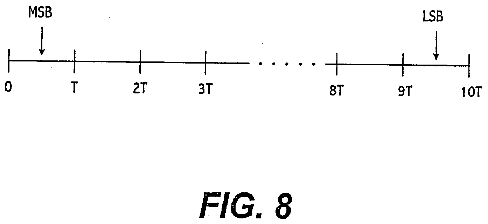

In contrast, Fig. 8 illustrates a simplified timing diagram of the coarse tuning process according to embodiments of the present invention. Unlike the example in Fig. 7, the decision time for the each bit can set differently. The last bit (e.g., LSB) has a longer decision time and the first bit (e.g., MSB) has a shorter decision time. However, the duration of the each bit can be optimized according to the specific implementation of the coarse tuning algorithm. Therefore, weighting the decision time can provide accurate coarse tuning result, while also reducing coarse tuning time.

Adaptive time regulation for the coarse tuning according to embodiments of the present invention is provided by incorporating redundant weighting in the discrete capacitor array for the coarse tuning. Table 1 shows an example for the implementation of the capacitor array for the coarse tuning. However, those skilled in the art will appreciate other weighing schemes can be used. In Table 1, Caps(n) corresponds to the (n-th) capacitor used to tune the frequency of the VCO. For example, Caps(1) is the last capacitor to be selected through the coarse tuning process. Referring to Table 1, only the relative weighting factor for the capacitance value is shown. The weighting factors from Caps(10) to Caps(7) are selected by binary weighting for the wide VCO range. Further, the weighting factors from Caps(6) to Caps(1) can be selected, empirically from the trade-off the coarse tuning time and the redundancy margin. For example, the weighting of Caps(6) is 10 and the sum of the weightings from Caps(5) to Caps(1) is 16. So there is redundancy amount of 6 in Caps(6) level.

Since the frequency of the LC-VCO is determined by the equation of $\dfrac{1}{2\pi\sqrt{LC}}$, the relative weighting of the capacitance is sufficient to indicate the variation of the frequency. The redundancy R(i) in the Table 1 can be obtained using the weighting W(i) by equation (1) as follows.

$$R(i) = \max\left\{\left[\sum_{i=1}^{i-1} W(i) - W(i)\right], 0\right\}, where\ i \geq 2$$

$$R(1) = 0$$

$$(1)$$

Since the capacitance value corresponds with the frequency, the above equation indicates that the redundancy can be used to compensate error in the decision process. For example, R(10) is 10 and thus if the switch for the Caps(10) is selected in wrong way, this error can be corrected in the following decision process. However, when the polarity of the switch for Caps(10) is set to zero by unexpected error in the decision logic and the amount of the redundancy is negative unlike Table.1. The coarse tuning process cannot resolve the frequency error caused by this negative redundancy. In an ideal situation, if the decision process is perfect and the redundancy can be all set to zero, then the result of the coarse tuning will also be ideal and the resulting accuracy will be determined by the smallest weighting factor. However, in practical implementations of the capacitor array, there is some mismatch between two binary-weighted capacitors. If there is no redundancy for the lower bits, this mismatch at certain stage cannot be resolved. Since the amount of the mismatch is proportional to the weighting factor, the frequency error caused by the mismatch will be less severe for capacitor arrays with smaller weighting factors. For example, a 10% error for two binary weighted capacitors, 64 and 1, will result in the error of the capacitance, 6.4 and 0.1, respectively. If the final resolution of the tuning capacitor is assumed to be one, a 10% error in the most-significant bit will give too large an error for the frequency calculation. Thus, the redundancy is usually given to high index (e.g., MSB) value rather than the low index as illustrated in Table 1.

Table 1.

| Capacitor Caps (n) | Weighting W(n) | Redundancy Amount R(n) |
|---|---|---|
| Caps(1) | 1 | 0 |

(continued)

| Capacitor Caps (n) | Weighting W(n) | Redundancy Amount R(n) |
|---|---|---|
| Caps(2) | 2 | 0 |
| Caps(3) | 3 | 0 |
| Caps(4) | 4 | 2 |
| Caps(5) | 6 | 4 |
| Caps(6) | 10 | 6 |
| Caps(7) | 16 | 10 |
| Caps(8) | 32 | 10 |
| Caps(9) | 64 | 10 |
| Caps(10) | 128 | 10 |

Although redundancy in an array of capacitors can intentionally be made to compensate for fabrication mismatch of the capacitor array, this property can also be used to reduce the coarse tuning time effectively. Even though some uncertainty or error happens to exist in the decision process of the coarse tuning, those errors or uncertainty will be corrected if amount of the error is smaller than the redundancy amount at that specific index.

For example, assuming that the desired target frequency corresponds to "130" as the sum of the weighted capacitance, the coarse tuning values of Caps(10) and Caps(2) should be set to one (e.g., switched on) in the ideal case. For example, referring to Fig. 6, even though the Caps(10) is set to one, the lead-and-lag detection logic produces the comparison result of "UP". Accordingly, the frequency of the VCO should be increased. In this case, it is assumed that the frequency increases as the number of weighted capacitor increases. Thus, the effective frequency of the VCO with "1" of Caps(10) is slower than the target frequency with "130" of the effective weighting value. If the decision logic has some offset and, for example, that value is "3", then the coarse tuning value for Caps(10) will be one rather than zero. Since the weighting factor given to the capacitor is a factor to determine the operating frequency of the VCO, the offset value is directly expressed as timing error when converted to the time domain from the frequency domain.

For example, if the unit value of "1" corresponds to a period error of 3ns, then an offset value "3" indicates that the coarse tuning process has a 9ns offset at its decision. This timing error can be corrected by increasing the comparison time for each bit. Assuming that only the first decision process has decision error for simplicity, then the remaining coarse tuning decision will be correct. Thus, the Caps(10-1) from the coarse tuning will be [0111101101] to get the total weighted value of 130. Even though the above example is simplified for the decision error, it is clear that the redundancy helps to compensate the decision error at certain stage. Redundancy in Caps(N) level, where $N \geq 2$, is the difference between the sum of Caps from N-1 to 1 and Caps(N). For example, the target VCO frequency is "13". Let's assume there is a decision error in Caps(6) level and, therefore, Caps(6) is erroneously selected as "0", instead of the correct "1". Because the weighting of the Caps(6) is "10" and selected as "0", the rest of the Caps(i.e. Caps(5-1)) should be selected to cover the target VCO frequency. As a result, Caps, [0000011100], instead of [0000100100] is selected. So, in case there are decision errors, the rest of the stages can cover the error with the help of redundancy.

The amount of the mismatch in two binary-weighted capacitor arrays is typically larger than error sources from the decision logic. Thus, the redundancy value is designed to be able to compensate for the mismatch rather than the error in the decision process of the coarse tuning. Therefore, the timing error during the decision process has less impact on the accuracy of the coarse tuning. Thus, the duration of the coarse tuning can be reduced if there is large redundancy. Since the extension of the duration of the comparison time (e.g., as illustrated in Fig. 5) can reduce the effect from the decision process, the most accurate decision or longest comparison time can be made when the redundancy is zero. In the particular example of Table.1, the coarse tuning controller should have the most accurate decision when it decides the switching polarity of Caps(3-1) where the redundancy is zero. The comparison accuracy for the other bits can be relaxed and thus smaller comparison time can be allowed.

As stated before, when the comparison time is doubled, the accuracy of the coarse tuning process is typically doubled. Assuming that $T_{min}$ is the minimum 1-bit comparison time required for Caps(1-3), the comparison time for Caps(4) can have the value of $T_{min}/2$ to give correct coarse tuning result. Likewise, the comparison time of $T_{min}/10$ can be used for Caps(10), which will have the same probability of error with that of $T_{min}$ for Caps(1-3). The following table illustrates one example procedure for timing according to embodiments of the present invention.

| PROCEDURE | OPERATIONS |
|---|---|
| Cycle 12 | Set Cas[10:1] = "01111111111" |
| Cycle 11 | If VCO too slow, set Caps[10] to "1" and set Caps[9] to "0". |
|  | If VCO too fast, set Caps[9] to "0". |
| Cycle 10 | If VCO too slow, set Caps[9] to "1" and set Caps[8] to "0". |
|  | If VCO too fast, set Caps[8] to "0". |
| Cycle 9 | If VCO too slow, set Caps[8] to "1" and set Caps[7] to "0". |
|  | If VCO too fast, set Caps[7] to "0". |
| Cycle 8 | If VCO too slow, set Caps[7] to "1" and set Caps[6] to "0". |
|  | If VCO too fast, set Caps[6] to "0". |
| Cycle 7 | If VCO too slow, set Caps[6] to "1" and set Caps[5] to "0". |
|  | If VCO too fast, set Caps[5] to "0". |
| Cycle 6 | If VCO too slow, set Caps[5] to "1" and set Caps[4] to "0". |
|  | If VCO too fast, set Caps[4] to "0". |
| Cycle 5 | If VCO too slow, set Caps[4] to "1" and set Caps[3] to "0". |
|  | If VCO too fast, set Caps[3] to "0". |
| Cycle 4 | If VCO too slow, set Caps[3] to "1" and set Caps[2] to "0". |
|  | If VCO too fast, set Caps[2] to "0". |
| Cycle 3 | If VCO too slow, set Caps[2] to "1" and set Caps[1] to "0". |
|  | If VCO too fast, set Caps[1] to "0". |
| Cycle 2 | If VCO too slow, set Caps[1] to "1" and set Caps[0] to "0". |
|  | If VCO too fast, set Caps[0] to "0". |
| Cycle 1 | If VCO too slow, set Caps[0] to "1". |
|  | If VCO too fast, set Caps[0] to "0". |

As illustrated in Table 2, multiple bits are switched in a different way than disclosure in the related art. Caps can be switched from the MSB to LSB in pairs, sequentially. For example, in the first stage, Caps(10) and Caps(9) are selected. In the second stage, Caps(9) and Caps(8) are selected. Coarse tuning time is limited by the longest comparison time between neighboring Caps, Caps(N) and Caps(N-1). In contrast in the related art, Caps(6) and Caps(3) are switched at the same stage, thus, coarse tuning time is limited by the redundancy amount of Caps(3). However, according to the broadwork of the present invention, Caps(6) and Caps(5) are switched at the same stage, thus, coarse tuning time is limited by that of Caps(5), not Caps(3). Accordingly, coarse tuning time can be significantly reduced compared to the related art systems.

If the same comparison cycle time is applied for the coarse tuning, the total time for the coarse tuning will be $10 * T_{min}$. However, when the adaptive optimization for the comparison time is made, the total coarse tuning time will be reduced. For example, the course tuning time of Table 1 is $\frac{259}{60} T_{min}$ (i.e., $\frac{T_{min}}{10} 4 + \frac{T_{min}}{6} + \frac{T_{min}}{4} + \frac{T_{min}}{2} + T_{min} 3$). Thus, the total coarse tuning is reduced by greater than two times with essentially the same accuracy. Accordingly, accurate coarse tuning can be performed by using the adaptive scaling for the comparison time as described in embodiments of the present invention. The accurate coarse tuning also allows for a smaller size of the analog varactor, which improves phase noise performance.

Additionally, the total lock time can be reduced or made consistent across all conditions by employing techniques described with reference to embodiments of the present invention. The coarse tuning process is digital and thus its functionality and the operating time is determined by the initial design. However, the phase lock operation after the coarse tuning is affected by the initial state of the PFD, the amount of the frequency error, and the variation of the loop characteristics. Accurate coarse tuning reduces the frequency error to the target frequency after the coarse tuning, and thus the maximum value of the frequency error can be reduced. Accordingly, the time required to obtain frequency and phase lock can be reduced. Thus, the total lock time can be regulated and reduced over all initial frequency errors by the accurate coarse tuning.

The overhead due to accurate coarse tuning is greatly relaxed due to the adaptation of the comparison time in embodiments of present invention. The overhead for the accurate coarse tuning and increase of number of bits to be decided are nulled by the regulation of the coarse tuning time and the time reduction of the phase lock operation. Accordingly, embodiments of the present invention can reduce the time of coarse tuning in LC-VCOs and thus reduce the lock time of PLLs.

**EP 1 716 634 B1**

The foregoing description relates to coarse tuning methods and apparatuses for LC oscillators to improve the phase noise performance and to increase the operating range of the LC oscillator. The coarse tuning increases the effective lock time of the PLL and this overhead increases as the desired accuracy of the coarse tuning increases. In embodiments of the present invention, the bit-comparison time is adaptively controlled to provide the smallest coarse tuning time. The redundancy in the weighted capacitor array for the coarse tuning allows for reduced comparison times without sacrificing the accuracy of the coarse tuning. The bit comparison time is scaled according to the amount of the redundancy. Since the redundancy of the weighted capacitor is used to compensate for the mismatch in the capacitance, the use of this property to reduce the coarse tuning is not an additional burden. Further, if the same time limit on the coarse tuning time is used, embodiments of the present invention can increase the accuracy of the coarse tuning. Since accurate coarse tuning can reduce the operating time and the time variation for the phase lock operation, embodiments of the present invention can reduce lock time of PLLs.

The foregoing embodiments and advantages are merely exemplary and are not to be construed as limiting the present invention. The present teaching can be readily applied to other types of apparatuses. The description of the present invention is intended to be illustrative, and not to limit the scope of the claims. Many alternatives, modifications, and variations will be apparent to those skilled in the art. In the claims, means-plus-function clauses are intended to cover the structures described herein as performing the recited function and not only structural equivalents but also equivalent structures.

**Claims**

1. A phase lock loop comprising:
   an inductor-capacitor voltage controlled oscillator "LC-VCO", the LC-VCO comprising:

      a capacitor array having a plurality of capacitors, wherein the capacitances of the plurality of capacitors are non-linearly weighted to provide redundancy; and
      a coarse tuning controller configured to perform coarse tuning comprising: selecting a capacitor from the plurality of capacitors; and providing a comparison time for comparing an output frequency of the LC-VCO to a reference value, **characterised in that** the comparison time is based on the redundancy associated with the weighting of the selected capacitor.

2. A phase lock loop as claimed in claim 1, wherein the plurality of capacitors comprise a first subset of capacitors that have capacitances which are linearly weighted and a second subset of capacitors that have capacitances which are binary weighted.

3. A method of tuning a circuit comprising a PLL that comprises an inductor-capacitor voltage controlled oscillator "LC-VCO", the LC-VCO comprising: a capacitor array having a plurality of capacitors, wherein the capacitances of the plurality of capacitors are non-linearly weighted to provide redundancy and the circuit comprising a coarse tuning controller configured to perform coarse tuning, the method comprising:

      selecting a capacitor from the plurality of capacitors;
      providing a comparison time of a circuit for comparing an output frequency of the LC-VCO to a reference value, **characterised in that** the comparison time is based on the redundancy associated with the weighting of the selected capacitor.

**Patentansprüche**

1. Phasenregelkreis, der Folgendes umfasst:
   einen spannungsgesteuerten Oszillator mit Induktivität und Kondensator bzw. "LC-VCO", wobei der LC-VCO Folgendes umfasst:

      ein Kondensatorarray mit mehreren Kondensatoren, wobei die Kapazitäten der mehreren Kondensatoren nichtlinear gewichtet sind, um Redundanz bereitzustellen; und
      eine Grobabstimmungssteuerung, die konfiguriert ist zum Durchführen einer Grobabstimmung, die Folgendes umfasst: Auswählen eines Kondensators aus den mehreren Kondensatoren und Bereitstellen einer Vergleichszeit zum Vergleichen einer Ausgangsfrequenz des LC-VCO mit einem Referenzwert, **dadurch gekennzeichnet, dass** die Vergleichszeit auf der Redundanz basiert, die mit der Gewichtung des ausgewählten Kondensators assoziiert ist.

**2.** Phasenregelkreis nach Anspruch 1, wobei die mehreren Kondensatoren eine erste Teilmenge von Kondensatoren, die Kapazitäten aufweisen, die linear gewichtet sind, und eine zweite Teilmenge von Kondensatoren, die Kapazitäten aufweisen, die binär gewichtet sind, umfassen.

**3.** Verfahren zum Abstimmen einer Schaltung, die einen PLL umfasst, der einen spannungsgesteuerten Oszillator mit Induktivität und Kondensator bzw. "LC-VCO" umfasst, wobei der LC-VCO Folgendes umfasst: ein Kondensatorarray mit mehreren Kondensatoren, wobei die Kapazitäten der mehreren Kondensatoren nichtlinear gewichtet sind, um Redundanz bereitzustellen, und die Schaltung eine Grobabstimmungssteuerung umfasst, die konfiguriert ist zum Durchführen einer Grobabstimmung, wobei das Verfahren Folgendes umfasst:

Auswählen eines Kondensators aus den mehreren Kondensatoren;
Bereitstellen einer Vergleichszeit einer Schaltung zum Vergleichen einer Ausgangsfrequenz des LC-VCO mit einem Referenzwert, **dadurch gekennzeichnet, dass** die Vergleichszeit auf der Redundanz basiert, die mit der Gewichtung des ausgewählten Kondensators assoziiert ist.

## Revendications

**1.** Boucle à verrouillage de phase comprenant :
un oscillateur commandé en tension à inducteur-condensateur "LC-VCO", le LC-VCO comprenant :

un réseau de condensateurs ayant une pluralité de condensateurs, dans lequel les valeurs de capacité de la pluralité de condensateurs sont pondérées non linéairement pour assurer une redondance ; et
une unité de commande d'accord grossier configurée pour exécuter un accord grossier comprenant : la sélection d'un condensateur parmi la pluralité de condensateurs ; et la fourniture d'un temps de comparaison pour comparer une fréquence de sortie du LC-VCO à une valeur de référence, **caractérisée en ce que** le temps de comparaison est basé sur la redondance associée à la pondération du condensateur sélectionné.

**2.** Boucle à verrouillage de phase selon la revendication 1, dans lequel la pluralité de condensateurs comprend un premier sous-ensemble de condensateurs qui ont des valeurs de capacité pondérées linéairement et un second sous-ensemble de condensateurs qui ont des valeurs de capacité pondérées de façon binaire.

**3.** Procédé d'accord d'un circuit comprenant une PLL qui comprend un oscillateur commandé en tension à inducteur-condensateur "LC-VCO", le LC-VCO comprenant : un réseau de condensateurs ayant une pluralité de condensateurs, dans lequel les valeurs de capacité de la pluralité de condensateurs sont pondérées non linéairement pour assurer une redondance ; et le circuit comprenant une unité de commande de d'accord grossier configurée pour exécuter un accord grossier, le procédé comprenant :

la sélection d'un condensateur parmi la pluralité de condensateurs ;
la fourniture d'un temps de comparaison pour comparer une fréquence de sortie du LC-VCO à une valeur de référence, **caractérisé en ce que** le temps de comparaison est basé sur la redondance associée à la pondération du condensateur sélectionné.

EP 1 716 634 B1

*FIG. 1*

FIG. 2

FIG. 3

EP 1 716 634 B1

FIG. 4

EP 1 716 634 B1

FIG. 5

503
502
504 DIVIDER
505 DIGITAL COMPARATOR
501 BIAS GENERATOR
VARACTORS
INTEGRATED VCO
308
RF OUT
312,318
FREQ. UP/DOWN
510 COARSE TUNING CONTROLLER
SW,SW'
314,316
COARSE TUNING CAPACITOR ARRAYS
506 PRESCALER & COUNTER
507 RESET GENERATOR & COUNTER CONTROLLER

EP 1 716 634 B1

15

FIG. 6

FIG. 7

EP 1 716 634 B1

MSB

LSB

0  T  2T  3T  . . . . .  8T  9T  10T

*FIG. 8*

*FIG. 9*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20020193084 A1

- US 6137372 A

**Non-patent literature cited in the description**

- A CMOS Self-Calibrating Frequency Synthesizer. *IEEE Journal of solid-state circuits,* 2000, vol. 35 (10